# EUROPEAN PATENT SPECIFICATION

(11) **EP 1 263 138 B1**
(45) Date of publication and mention of the grant of the patent: **08.03.2006**
(21) Application number: 02253160.2
(22) Date of filing: 04.05.2002
(51) Int. Cl.: H03J 5/24

(54) **Television tuner**
Fernsehtuner
Circuit d'accord de télévision

(30) Priority: 31.05.2001 JP 2001165802
(43) Date of publication of application: 04.12.2002
(73) Proprietor: ALPS ELECTRIC CO., LTD., Ota-ku Tokyo (JP)
(72) Inventor: Yamamoto, Masaki, c/o Alps Electric Co. Ltd., Tokyo (JP)
(74) Representative: Kensett, John Hinton

(56) References cited:
- EP-A- 0 457 932
- US-A- 3 980 957
- PATENT ABSTRACTS OF JAPAN vol. 015, no. 219 (E-1074), 5 June 1991 (1991-06-05) & JP 03 062718 A (MATSUSHITA ELECTRIC IND CO LTD), 18 March 1991 (1991-03-18)

## Description

### BACKGROUND OF THE INVENTION

### 1. Field of the Invention

The present invention as it is defined in the independent claim relates to a television tuner including a band-switching tuned circuit system which is tuned to a high band or a low band, and a band-switching circuit system for controlling the band switching of the above-described tuned circuit. The document EP-A-0 457 932 disclose as example of a tuner including a band switching.

### 2. Description of the Related Art

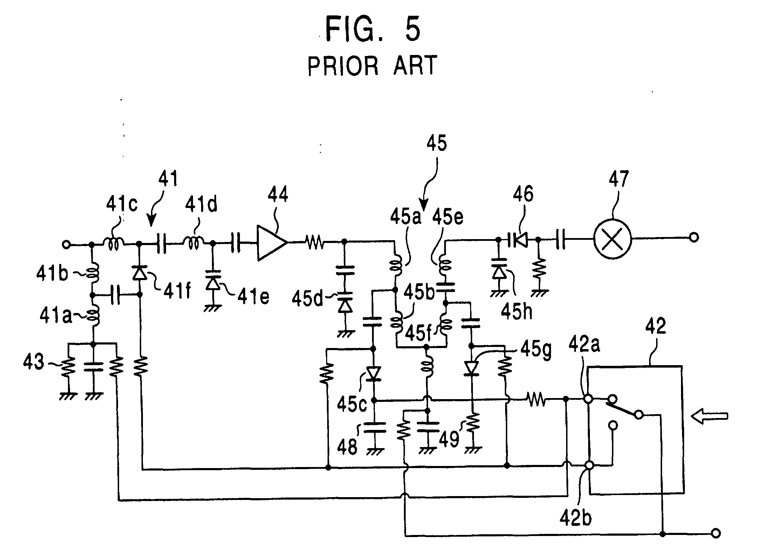

The circuit of a known television tuner is shown in Fig. 5. An input tuned circuit system 41 for receiving VHF television signals includes: a single tuned circuit provided with four series-connected inductance devices 41a, 41b, 41c, and 41d, and a varactor diode 41e; and a switch diode 41f connected in parallel to the two inductance devices 41b and 41c. With this configuration, the input tuned circuit system 41 can be switched and tuned to a high band or a low band by switching the switch diode 41f to ON or OFF. The switch diode 41f is switched to ON or OFF by a band-switching circuit system 42. The cathode of the switch diode 41f is grounded by a resistor 43 and is connected to a first terminal 42a of the band-switching circuit system 42, and the anode thereof is connected to a second terminal 42b.

The band-switching circuit system 42 has a built-in switch circuit 42c, which is controlled by an input band switching signal S. When a high-band television signal is received, a high-level switching voltage is output to the second terminal 42b. When a low-band television signal is received, a high-level switching voltage is output to the first terminal 42a.

A high frequency amplifier 44 is disposed at the subsequent stage of the input tuned circuit system 41, and an inter-stage tuned circuit 45 is provided at the subsequent stage of the high frequency amplifier 44.

The inter-stage tuned circuit 45 is formed of a double-tuned circuit. The following elements are provided at the primary side of the inter-stage tuned circuit 45. A first end of an inductance device 45a is connected to the output terminal of the high frequency amplifier 44. An inductance device 45b is connected in series to the inductance device 45a. A switch diode 45c is connected at one end to a node between the two inductance devices 45a and 45b and at the other end to a ground. A varactor diode 45d is connected between the first end of the inductance device 45a and a ground.

The following elements are provided at the secondary side of the inter-stage tuned circuit 45. A first end of an inductance device 45e is connected to a mixer 47 via a varactor diode 46. An inductance device 45f is connected in series to the inductance device 45e. A switch diode 45g is connected at one end to a node between the two inductance devices 45e and 45f and at the other end to a ground. A varactor diode 45h is connected between the first end of the inductance device 45e and a ground.

A local oscillation signal from a local oscillator is input into the mixer 47, and a tuning voltage is applied to the cathodes of the varactor diodes 41e, 45d, 45h, and 46, though not shown.

The inductance device 45b of the primary side and the inductance device 45f of the secondary side are connected to each other, and a node therebetween is grounded in a high frequency range by a coupling inductance device 45i.

The cathodes of the switch diodes 45c and 45g are connected to each other, and are grounded for DC voltage in a high frequency range by a DC-cut capacitor 48 and a resistor 49, respectively. The cathodes of the switch diodes 45c and 45g are connected to the first terminal 42a of the band-switching circuit system 42, and the anodes thereof are connected to the second terminal 42b.

In the above-configured television tuner, when a high-band television signal is received, the second terminal 42b of the band-switching circuit system 42 becomes a high level so as to turn on the switch diodes 41f, 45c, and 45g. Thus, the input tuned circuit system 41 and the inter-stage tuned circuit 45 are tuned to a high band. When a low-band television signal is received, the first terminal 42a of the band-switching circuit system 42 becomes a high level so as to turn off the switch diodes 41f, 45c, and 45g. Thus, the input tuned circuit system 41 and the inter-stage tuned circuit 45 are tuned to a low band.

In the above-described known configuration, a switching voltage is applied separately to the anode and the cathode of each switch diode. Additionally, two switching terminals for outputting switching voltages are provided for the band-switching circuit system so that they are separately connected to the anode and the cathode of each switch diode. Accordingly, the wiring becomes complicated, and the configuration of the band-switching circuit system is also restricted.

### SUMMARY OF THE INVENTION

Accordingly, it is an object of the present invention to implement a simple connection between switch diodes and a band-switching circuit system, and also to enable the use of two different types of band-switching circuit systems.

In order to achieve the above object, a television tuner of the present invention includes a band-switching tuned circuit system provided with a switch diode. The band-switching tuned circuit system is switched to be tuned to a high band or a low band according to whether the switch diode is turned on or turned off. A band-switching circuit system is provided to control band switching of the band-switching tuned circuit system. A printed circuit board is provided on which at least the band-switching tuned circuit system and the band-switching circuit system are mounted. The band-switching circuit system includes at least a switch transistor which is turned on when the band-switching tuned circuit system is tuned to the high band and which is turned off when the band-switching tuned circuit system is tuned to the low band. A high-level voltage is applied to the anode of the switch diode. A first connecting land connected to the collector of the switch transistor and a second connecting land connected to the cathode of the switch diode are disposed on the printed circuit board. A conductive connector or an inverter is connected between the first connecting land and the second connecting land.

With the above-described configuration, the connection between the switch diode and the band-switching circuit system can be simplified. When an NPN transistor is used in the band switching circuit, the conductive connector is connected between the first and second connecting lands. When a PNP transistor is used in the band-switching circuit system, the inverter is connected between the first and second connecting lands. Thus, either type of band-switching circuit system can be used, in which case, the switch diode can be turned on when a high-band television signal is received, and the switch diode can be turned off when a low-band television signal is received.

In the aforementioned television tuner, a third connecting land, which is grounded, may be provided in the vicinity of the first and second connecting lands on the printed circuit board. The inverter may be formed of an NPN transistor, the base of the NPN transistor being connected to the first connecting land, the collector of the NPN transistor being connected to the second connecting land, and the emitter of the NPN transistor being connected to the third connecting land.

With this arrangement, when a PNP transistor is used in the band-switching circuit system, the switch diode can be turned on or off by the NPN transistor.

An embodiment of the present invention will now be described, by way of example, with reference to the accompanying diagrammatic drawings, in which:
Fig. 1 is a circuit diagram illustrating a television tuner of the present invention;
Fig. 2 is a circuit diagram illustrating a television tuner according to a first embodiment of the present invention;
Fig. 3 is a circuit diagram illustrating a television tuner according to a second embodiment of the present invention;
Fig. 4 illustrates a pattern of connecting lands used in the television tuner of the present invention; and
Fig. 5 is a circuit diagram illustrating a known television tuner.

### DESCRIPTION OF THE PREFERRED EMBODIMENTS

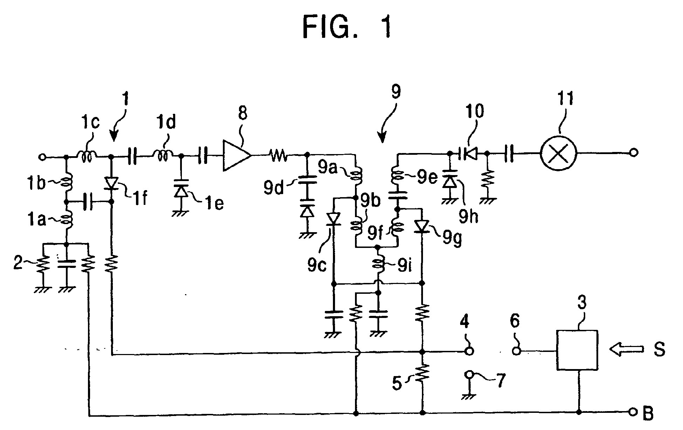

A television tuner of the present invention is described below with reference to Figs. 1 through 4.

Fig. 1 is a circuit diagram illustrating a television tuner of the present invention. The circuit shown in Fig. 1 is formed on a printed circuit board (not shown). A VHF television signal received by an antenna (not shown) is input into an input tuned circuit system 1. The input tuned circuit system 1 includes: a single tuned circuit provided with four series-connected inductance devices 1a, 1b, 1c, and 1d, and a varactor diode 1e; and a switch diode 1f connected in parallel to the two inductance devices 1b and 1c. The anode of the switch diode 1f is grounded by sequentially passing through the inductance devices 1c, 1b, and 1a, and a resistor 2, and is also connected to a power supply terminal B.

The switch diode 1f is switched by the band-switching circuit system 3 such that it is turned on when a high-band television signal is received, and it is turned off when a low-band television signal is received. The cathode of the switch diode 1f is connected to a second connecting land 4 formed on the printed circuit board. The second connecting land 4 is connected to the power supply terminal B by a pull-up resistor 5.

The band-switching circuit system 3 includes a built-in PNP-type or NPN-type switch transistor, which is discussed below, and the switch transistor is turned on or off by an input band switching signal S. That is, when a high-band television signal is received, the switch transistor is turned on, and when a low-band television signal is received, the switch transistor is turned off. The collector of the switch transistor is connected to a first connecting land 6 formed on the printed circuit board. The first connecting land 6 is provided in the vicinity of the second connecting land 4, and a conductive connector or an inverter, which is discussed below, is connected between the first and second connecting lands 6 and 4. A third connecting land 7, which is grounded, is provided in the vicinity of the first and second connecting lands 6 and 4.

A high frequency amplifier 8 is provided at the subsequent stage of the input tuned circuit system 1, and a band-switching inter-stage tuned circuit 9 is provided at the subsequent stage of the high frequency amplifier 8.

The inter-stage tuned circuit 9 is formed of a double-tuned circuit. The following elements are provided at the primary side of the inter-stage tuned circuit 9. A first end of an inductance device 9a is connected to the output terminal of the high frequency amplifier 8. An inductance device 9b is connected in series to the inductance device 9a. The anode of a switch diode 9c is directly connected to the node between the two inductance devices 9b and 9c, and the cathode thereof is connected to a ground in a high frequency range. A varactor diode 9d is connected between the first end of the inductance device 9a and a ground.

The following elements are provided at the secondary side of the inter-stage tuned circuit 9. A first end of an inductance device 9e is connected to a mixer 11 via a varactor diode 10. An inductance device 9f is connected in series to the inductance device 9e. The anode of a switch diode 9g is connected to a node between the two inductance devices 9e and 9f, and the cathode thereof is connected to a ground in a high frequency range. A varactor diode 9h is connected between the first end of the inductance device 9e and a ground.

One end of a coupling inductance device 9i is connected to the inductance device 9b of the primary side and to the inductance device 9f of the secondary side. The other end of the coupling inductance device 9i is connected to a ground in a high frequency range, and is also connected to the power supply terminal B. As a result, a voltage is constantly applied to the anodes of the two switch diodes 9c and 9g from the power supply terminal B.

The cathodes of the switch diodes 9c and 9g are connected to the second connecting land 4. When a high-band television signal is received, the switch diodes 9c and 9g are turned on by the band-switching circuit system 3. When a low-band television signal is received, the switch diodes 9c and 9g are turned off by the band-switching circuit system 3. Accordingly, the inter-stage tuned circuit 9 is switched on or off so that it is tuned to a high band or a low band.

A tuning voltage is applied to the cathodes of the varactor diodes 1e, 9d, 9h, and 10, though not shown. An oscillation signal output from a local oscillator (not shown) is input into the mixer 11.

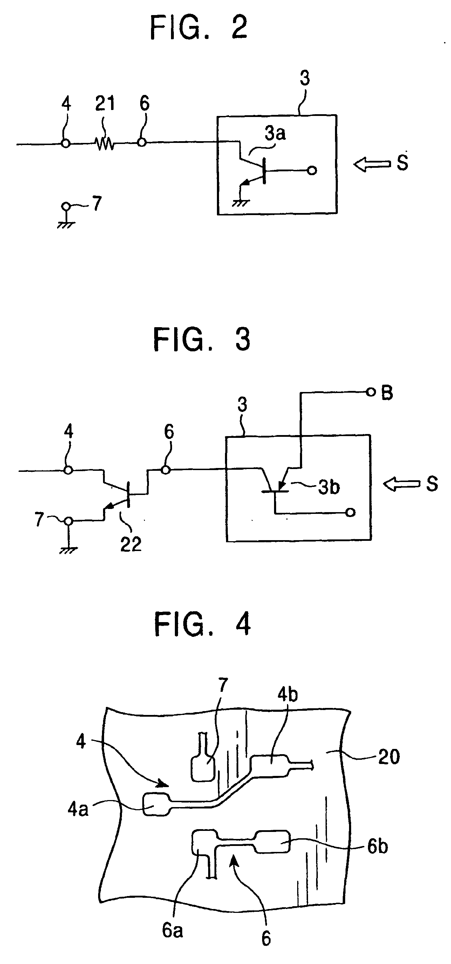

Fig. 2 illustrates one embodiment of the above-configured television tuner of the present invention. It is now assumed that the band-switching circuit system 3 uses an NPN transistor 3a in the above-described configuration. In this case, as shown in Fig. 2, the NPN transistor 3a connects to a conductive connector 21, formed of a resistor or a conductor, disposed between the first and second connecting lands 6 and 4. Then, the collector of the NPN transistor 3a is pulled up to the power supply terminal B via the conductive connector 21 by the switch diodes 1f, 9c, and 9g.

In this state, when a high-band television signal is received, the NPN transistor 3a is turned on to decrease the collector voltage, thereby turning on the switch diodes 1f, 9c, and 9g. As a result, the input tuned circuit system 1 is tuned to a high band by the inductance devices 1a and 1d, and the varactor diode 1e. The tuning frequency is changed by the tuning voltage applied to the varactor diode 1e.

The primary side of the inter-stage tuned circuit 9 is tuned to a high band by the inductance device 9a and the varactor diode 9d, and the secondary side of the inter-stage tuned circuit 9 is tuned to a high band by the inductance device 9e and the varactor diode 9h. The tuning frequency is changed by the tuning voltage applied to the varactor diodes 9d and 9h.

In contrast, when a low-band television signal is received, the NPN transistor 3a is turned off. In this case, the switch diodes 1f, 9c, and 9g are turned off since a voltage from the power supply terminal B is applied to the cathodes of the switch diodes 1f, 9c, and 9g. As a result, the inductance devices 1b and 1c are added to the input tuned circuit system 1, which is then tuned to a low band. Also in the inter-stage tuned circuit 9, the inductance device 9b is added to the primary side, and the inductance device 9f is added to the secondary side, and thus, the inter-stage tuned circuit 9 is tuned to a low band.

Fig. 3 illustrates another embodiment of the television tuner of the present invention. It is now assumed that the band-switching circuit system 3 uses a PNP transistor 3b. In this case, as shown in Fig. 3, an inverter 22, such as an NPN transistor, is connected between the first and second connecting lands 6 and 4. A voltage from the power supply terminal B is supplied to the emitter of the PNP transistor 3b. If the inverter 22 is an NPN transistor, the collector of the PNP transistor 3b is connected to the base of the NPN transistor 22, and the emitter of the NPN transistor 22 is connected to a third connecting land 7. The collector of the PNP transistor 3b is pulled up to the power supply terminal B by the switch diodes 1f, 9c, and 9g.

In this case, when a high-band television signal is received, the PNP transistor 3b and the NPN transistor 22 are turned on, and then, the switch diodes 1f, 9c, and 9g are turned on. When a low-band television signal is received, the PNP transistor 3b and the NPN transistor 22 are turned off, and then, the switch diodes 1f, 9c, and 9g are turned off.

Fig. 4 illustrates an example of a specific pattern of the first, second, and third connecting lands 6, 4, and 7 formed on a printed circuit board 20. However, the connecting lands 6, 4, and 7 are not restricted to this pattern. The first connecting land 6 includes a first connecting portion 6a and a second connecting portion 6b. The second connecting land 4 includes a first connecting portion 4a and a second connecting portion 4b. The first connecting portion 6a of the first connecting land 6, the first connecting portion 4a of the second connecting land 4, and the third connecting land 7 are disposed such that they form vertices of a triangle. The second connecting portion 6b of the first connecting land 6 and the second connecting portion 4b of the second connecting land 4 are disposed such that they oppose each other. The conductive connector 21 is connected between the second connecting portions 6b and 4b, or the NPN transistor 22 is connected between the first connecting portions 6a, 4a, and the third connecting land 7.

## Claims

1. A television tuner comprising:
a band-switching tuned circuit system including a switch diode (17), said band-switching tuned circuit system being switched to be tuned to a high band or a low band according to whether the switch diode (17) is turned on or turned off;
a band-switching circuit system for controlling band switching of said band-switching tuned circuit system; and
a printed circuit board on which at least said band-switching tuned circuit system and said band-switching circuit system are mounted,
wherein: said band-switching circuit system (3) includes at least a switch transistor (3b) which is turned on when said band-switching tuned circuit system is tuned to the high band and which is turned off when said band-switching tuned circuit system is tuned to the low band; a high-level voltage is applied to an anode of the switch diode (17); and a first connecting land (6) connected to a collector of the switch transistor and a second connecting land (4) connected to a cathode of the switch diode (17) are disposed on said printed circuit board, a conductive connector or an inverter being connectable between the first connecting land (6) and the second connecting land (4).

2. A television tuner according to claim 1, wherein: a third connecting land (7), which is grounded, is provided in a vicinity of the first (6) and second (9) connecting lands on said printed circuit board; and the inverter is formed of an NPN (22) transistor, a base of the NPN transistor being connected to the first connecting land (6), a collector of the NPN transistor being connected to the second connecting land (4), and an emitter of the NPN transistor being connected to the third connecting land (7).

## Revendications

1. Sélecteur de canaux de télévision comprenant :
un système de circuit accordé à commutation de bandes de fréquences incluant une diode de commutation (1f), ledit système de circuit accordé à commutation de bandes de fréquences étant commuté pour être accordé sur une bande haute ou sur une bande basse, selon que la diode de commutation (1f) est sous tension ou hors tension ;
un système de circuit à commutation de bandes de fréquences permettant de commander la commutation de bandes dudit système de circuit accordé à commutation de bandes de fréquences ; et
une carte de circuit imprimé sur laquelle sont montés au moins ledit système de circuit accordé à commutation de bandes de fréquences et ledit système de circuit à commutation de bandes de fréquences,
dans lequel ledit système de circuit à commutation de bandes de fréquences (3) inclut au moins un transistor de commutation (3b) qui est mis sous tension lorsque ledit système de circuit accordé à commutation de bandes de fréquences est accordé sur la bande haute, et qui est mis hors tension lorsque ledit système de circuit accordé à commutation de bandes de fréquences est accordé sur la bande basse ; une tension à haut niveau est appliquée à une anode de la diode de commutation (1f) ; et une première plage de connexion (6) connectée à un collecteur du transistor de commutation ainsi qu'une deuxième plage de connexion (4) connectée à une cathode de la diode de commutation (1f) sont disposées sur ladite carte de circuit imprimé, un connecteur conducteur ou un inverseur pouvant être connecté entre la première plage de connexion (6) et la deuxième plage de connexion (4).

2. Sélecteur de canaux de télévision selon la revendication 1, dans lequel une troisième plage de connexion (7), qui est mise à la terre, est prévue à proximité des première (6) et deuxième (4) plages de connexion sur ladite carte de circuit imprimé ; et l'inverseur est constitué d'un transistor NPN (22), une base dudit transistor NPN étant connectée à la première plage de connexion (6), un collecteur dudit transistor NPN étant connecté à la deuxième plage de connexion (4), et un émetteur dudit transistor NPN étant connecté à la troisième plage de connexion (7).

## Patentansprüche

1. Fernsehtuner, aufweisend:
ein abgestimmtes Bandschaltschaltungssystem, das eine Schaltdiode (1f) umfasst, wobei das abgestimmte Bandschaltschaltungssystem so geschaltet ist, dass es in Abhängigkeit davon, ob die Schaltdiode (1f) eingeschaltet oder ausgeschaltet ist, auf ein hohes Band oder ein niedriges Band abgestimmt ist;
ein Bandschaltschaltungssystem zur Steuerung der Bandschaltung des abgestimmten Bandschaltschaltungssystems; und
eine Leiterplatte, auf die mindestens das abgestimmte Bandschaltschaltungssystem und das Bandschaltschaltungssystem montiert sind,
wobei: das Bandschaltschaltungssystem (3) mindestens einen Schalttransistor (3b) umfasst, der eingeschaltet ist, wenn das abgestimmte Bandschaltschaltungssystem auf das hohe Band abgestimmt ist, und der ausgeschaltet ist, wenn das abgestimmte Bandschaltschaltungssystem auf das niedrige Band abgestimmt ist; eine Hochpegelspannung an eine Anode der Schaltdiode (1f) angelegt wird; und eine erste mit einem Kollektor des Schalttransistors verbundene Verbindungsfläche (6) und eine zweite mit einer Kathode der Schaltdiode (1f) verbundene Verbindungsfläche (4) auf der Leiterplatte angeordnet sind, wobei ein leitender Verbinder oder ein Inverter eine Verbindung zwischen die erste Verbindungsfläche (6) und die zweite Verbindungsfläche (4) schaltbar ist.

2. Fernsehtuner nach Anspruch 1, wobei: auf der Leiterplatte eine dritte Verbindungsfläche (7), die masseverbunden ist, in einer Nachbarschaft der ersten (6) und der zweiten (4) Verbindungsfläche vorgesehen ist; und der Inverter aus einem NPN-Transistor (22) gebildet ist, wobei eine Basis des NPN-Transistors mit der ersten Verbindungsfläche (6) verbunden ist, ein Kollektor des NPN-Transistors mit der zweiten Verbindungsfläche (4) verbunden ist und ein Emitter des NPN-Transistors mit der dritten Verbindungsfläche (7) verbunden ist.
